## Europäisches Patentamt
## European Patent Office
## Office européen des brevets

(19)

(11) Numéro de publication: **0 164 292**
**B1**

(12)

# FASCICULE DE BREVET EUROPÉEN

(45) Date de publication du fascicule du brevet:
**14.10.87**

(51) Int. Cl.⁴: **H 01 L 29/743**

(21) Numéro de dépôt: **85401035.2**

(22) Date de dépôt: **28.05.85**

(54) Thyristor blocable à gachette d'anode.

(30) Priorité: **30.05.84 FR 8408493**

(43) Date de publication de la demande:
**11.12.85 Bulletin 85/50**

(45) Mention de la délivrance du brevet:
**14.10.87 Bulletin 87/42**

(84) Etats contractants désignés:
**CH DE FR GB LI NL**

(56) Documents cité:
**DE-A-2 804 443**
**US-A-4 089 024**
**US-A-4 236 169**

(73) Titulaire: **THOMSON SEMICONDUCTEURS, 101, bld Murat, F-75016 - Paris (FR)**

(72) Inventeur: **Pezzani, Robert, THOMSON- CSF SCPI 173, bld Haussmann, F-75379 Paris Cedex 08 (FR)**

(74) Mandataire: **Guérin, Michel, THOMSON- CSF SCPI 19, avenue de Messine, F-75008 Paris (FR)**

EP 0 164 292 B1

## Description

Les thyristors connus sont généralement formés par la superposition de quatre couches semiconductrices de types de conductivité N et P alternées: région d'anode de type P, région centrale de type N, région de gâchette de type P, région de cathode de type N. La région centrale de type N est la plus épaisse et la moins dopée; c'est elle qui sert à assurer la tenue en tension du thyristor dans l'état bloqué; elle est formée dès l'origine par le substrat semiconducteur de départ servant à la fabrication du thyristor. La région d'anode, de type P, est diffusée sur la face arrière du substrat, puis métallisée pour former une électrode d'anode. La région de gâchette, de type P, est diffusée ou épitaxiée sur la face avant du substrat, après quoi une région de cathode, de type N, est à nouveau diffusée sur la face avant, à l'intérieur de la région de gâchette. Cette diffusion de type N est localisée, c'est-à-dire qu'elle n'occupe pas toute la surface de la pastille, afin de laisser une zone superficielle d'accès à la région de gâchette. Une métallisation de cathode recouvre la région de cathode et une métallisation de gâchette recouvre la zone d'accès à la gâchette.

Un thyristor fonctionne normalement de la manière suivant: il bloque le courant entre anode et cathode tant qu'un courant de gâchette suffisant n'est pas appliqué. Lorsqu'un seuil de courant de gâchette est dépassé, le thyristor se déclenche et devient conducteur. Il reste alors conducteur même si le courant de gâchette disparaît, et ceci jusqu'à ce que le courant principal entre anode et cathode descende au-dessous d'un courant de maintien spécifique du thyristor. Le thyristor se rebloque alors.

Cependant, certains thyristors sont adaptés pour permettre un blocage par la gâchette (GTO: gate turn off thyristor, c'est-à-dire thyristor blocable par la gâchette). On applique un courant négatif à la gâchette pour bloquer ces thyristors même lorsqu'ils sont parcourus par un courant principal, entre anode et cathode, bien supérieur à leur courant de maintien. Ces thyristors ont notamment des structures de cathode et gâchette interdigitées afin que la gâchette puisse agir le plus possible sous la région de cathode.

Cependant ces thyristors GTO présentent une difficulté de réalisation et de fonctionnement. En effet, il est connu que le courant maximum ouvrable est inversement proportionnel à la résistance lamellaire de la couche P sous la couche d'émetteur N. Pour augmenter ce courant maximum ouvrable il est donc classique de chercher à accroître le dopage de la couche P pour réduire sa résistance. Cependant on constate une limitation: un trop fort dopage de cette couche P entraîne des caractéristiques anormales (analogues à la caractéristique d'un transistor fonctionnant en saturation: accroissement de la chute de tension à courant direct constant).

Pour améliorer les thyristors blocables par la gâchette, et en particulier pour faciliter le biocage par un courant de gâchette d'amplitude modérée même lorsque le thyristor est parcouru par un fort courant, la présente invention propose de modifier complètement la structure habituelle des thyristors, et de réaliser un thyristor à région de gâchette de type $N^+$ fortement dopée située entre la couche N peu dopée formant le substrat de départ et une région d'anode, l'accès à la région de gâchette se faisant par la surface de la pastille du côté de l'anode.

Plus précisément, le thyristor seion l'invention est constitué sur une pastille semiconductrice formée à partir d'un substrat de départ de type N peu dopé, la pastille comprenant principalement des régions de types de conductivité alternés et des métallisations superficielles d'anode, de cathode, et de gâchette; les métallisations d'anode et de gâchette sont situées sur une première face de la pastille et la métallisation de cathode sur la deuxième face; les régions semiconductrices alternées sont les suivantes: région N peu dopée du substrat de départ constituant une première couche centrale; region $N^+$ fortement dopée constituant une région de gâchette d'un côté de la première région centrale; région P diffusée localement dans la région de gâchette sur une partie seulement de la profondeur de celle-ci et constituant une région d'anode, la région de gâchette et la région d'anode affleurant toutes deux sur la première face de la pastille et étant recouvertes respectivement par la métallisation de gâchette et la métallisation d'anode; région P peu dopée constituant une deuxième région centrale de l'autre côté de la première région centrale; région N diffusée localement dans la deuxième région centrale de type P et constituant une région de cathode recouverte par la métallisation de cathode déposée uniformément sur la majeure partie de la deuxième face de la pastille.

Ainsi, tout en partant d'un substrat de départ de type N, ce qui est plus facile et donc moins coûteux indutriellement, on prévoit une region de gâchette de type N qui peut présenter par conséquent, pour un même niveau de dopage, une bien meilleure conductivité qu'une région de type P. Le passage de courant de la gâchette sous l'anode est rendu plus facile et les porteurs accumulés dans la région centrale N pendant la conduction du thyristor peuvent être plus facilement évacués par un courant de gâchette négatif destiné à bloquer le thyristor.

On notera que des thyristors blocables par la gâchette, ayant une gâchette située du côté de l'anode n'ont jamais été réalisés car on a toujours considéré non seulement qu'il n'y avait aucun intérêt à le faire mais qu'il y avait comme inconvénient non négligeable la nécessité de diffuser une région de type P (anode) à l'intérieur d'une région de type N assez fortement dopée, ce qui est beaucoup plus difficile que de diffuser une région de type P dans une substrat N peu dopé ou une région de type N fortement dopée dans une région de type P moyennement dopée (cas usuel des thyristors).

La presente invention propose donc de revenir sur ce préjugé pour permettre une amélioration des thyristors blocables par la gâchette.

D'autres caractéristiques et avantages de l'invention apparaîtront à la lecture de la description détaillée qui suit et qui est faite en référence aux dessins annexés dans lesquels:

- la figure 1 représente en coupe verticale une structure connue de thyristor blocable (GTO),

- la figure 2 représente en coupe verticale la structure correspondant à l'invention.

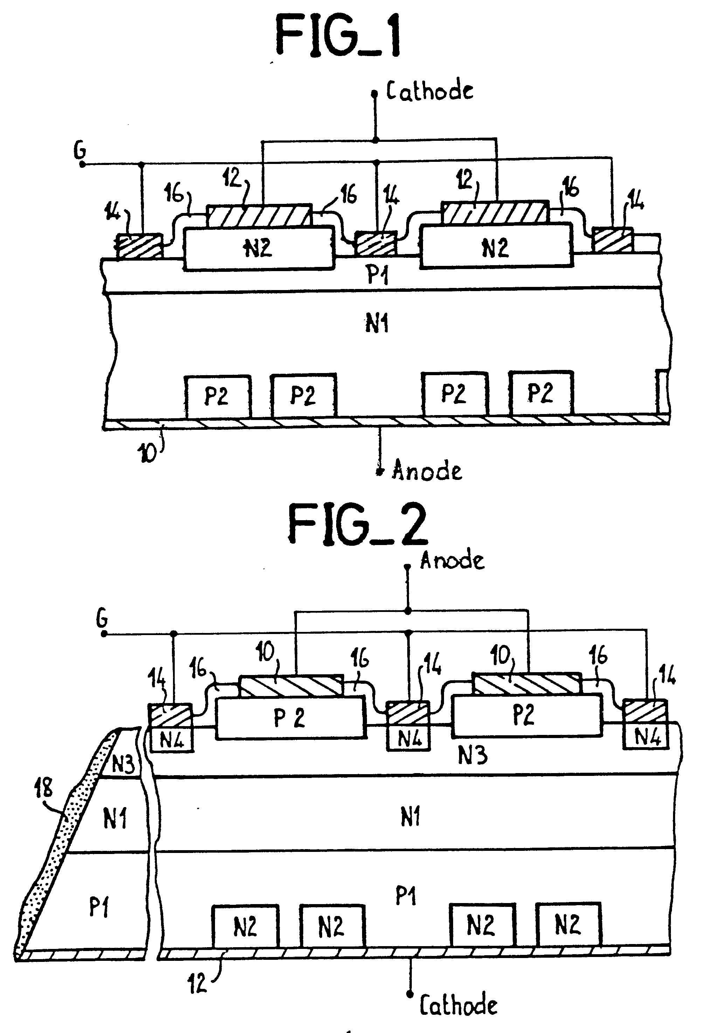

On ne reviendra pas sur la description des thyristors blocables de la technique antérieure: sur la figure 1, la région centrale peu dopée est désignée par N1, la région de gâchette par P1, la région de cathode par N2, la région d'anode par P2, la métallisation d'anode par 10 (face inférieure), la métallisation de cathode par 12 et la métallisation de gâchette par 14, toutes deux sur la face supérieure. Les régions de cathode et de gâchette sont interdigitées à la surface supérieure de la pastille, ainsi que les métallisations correspondantes, c'est-à-dire que des portions de la région de gâchette P1 affleurent à la surface entre des portions de la région de cathode N2. De préférence, les affleurements de la région de gâchette sont en creux par rapport aux affleurements de la région de cathode pour faciliter la séparation entre la prise de contact sur la métallisation de cathode et la prise de contact sur la métallisation de gâchette. Un isolant de passivation 16 est prévu sur les parties non métallisées de la surface supérieure. Sur la surface inferieure, entièrement métallisée, des trous de court-circuit sont prévus dans la région P2, trous par lesquels la région centrale N 1 rejoint la surface métallisée. Ces trous sont prévus pour l'évacuation plus rapide, au moment du blocage, des charges accumulées dans la région N 1 pendant la conduction.

La structure de thyristor ouvrable par la gâchette selon l'invention est représentée à la figure 2.

On a encore désigné par N1 une couche centrale peu dopée de type N formant l'essentiel du substrat de départ à partir duquel est formé le thyristor. On appellera cette couche N 1 première région centrale.

Au-dessous de la couche centrale N1 est disposée une couche P1 de type opposé, également peu dopée, qu'on appellera deuxième région centrale.

Sur une partie de l'épaisseur de la deuxième région centrale P1 est diffusée une région de cathode N2 fortement dopée; cette diffusion est de préférence localisée et laisse apparaître des zones (et notamment des trous de court-circuit) où la région P1 affleure sur la face arrière (deuxième face) de la pastille semiconductrice constituant le thyristor. L'ensemble de la surface arrière est recouvert d'une métallisation de cathode 12 qui vient en contact à la fois avec la région N2 (cathode) et des portions de la région P1 (deuxième région centrale).

De l'autre côté de la première région centrale N1, on trouve une couche N3 fortement dopée, qui est la région de gâchette dans laquelle est diffusée localement, sur une partie de son épaisseur seulement, une région d'anode P2.

Des portions de zone d'accès à la région de gâchette N3 sont prévues entre des portions de région d'anode P2, de préférence de manière interdigitée sous forme de doigts fins d'anode et de gâchette. Dans ces zones d'accès à la région de gâchette N3, cette région remonte à la surface (première face) de la pastille, et on peut prévoir que les zones d'accès sont encore plus dopées que la région de gâchette N3; c'est pourquoi on a désigné ces zones par la référence N4. Les régions d'anode P2 sont recouvertes d'une métallisation d'anode 10, tandis que les zones N4 d'accès à la région de gâchette N3 sont recouvertes d'une métallisation de gâchette 14. Ces métallisations sont interdigitées comme les régions qu'elles recouvrent. Entre les portions de métallisation, la surface non métallisée est recouverte par un isolant de passivation 16.

Les régions d'anode P2 et métallisations correspondantes 10 sont en relief par rapport aux zones d'accès à la gâchette N4 et aux métallisations correspondantes 14 pour faciliter la séparation des prises de contact avec ces métallisations.

On prévoit de préférence qu'en face des régions d'anode P2 il y a des régions de cathode N2, éventuellement avec un ou plusieurs petits trous de court-circuit central de désensibilisation où la région P1 rejoint la métallisation de cathode, tandis qu'en face des régions N4, d'autres zones, plus larges, de la région P1, rejoignent la métallisation de cathode.

Enfin, de préférence, les bords de la pastille sont fortement biseautés pour réduire le risque de claquage aux affleurements de jonction N1-P1 et le biseau est formé dans un sens tel que le bord biseauté fasse un angle aigu avec la face correspondant à la cathode, et un angle obtus avec la face correspondant à l'anode c'est-à-dire le contraire de ce qui est prévu pour les thyristors usuels. Cet angle est ici dans le sens favorable à l'amélioration de la tenue en tension du thyristor. Le bord biseauté de la tranche est recouvert d'un isolant de passivation 18.

Dans un exemple de procédé de fabrication, on part d'une rondelle de silicium de type N dont le dopage est choisi suivant les règles habituelles en fonction de la tenue en tension désirée. L'ordre de grandeur est de quelques $10^{13}$ atomes/cm$^3$ d'impuretés de type N.

Sur la première face de ce substrat, on réalise, par diffusion, implantation, ou épitaxie, une couche superficielle de type N plus fortement dopée, qui constituera la couche N3. L'impureté de dopage est de l'arsenic, du phosphore ou de l'antimoine. Si cette couche n'est pas réalisée par épitaxie, on procède à un traitement thermique à une température de 1 000 à 1 300°C pour obtenir finalement une couché N3 de 20 à 80 μm, de profondeur avec une concentration superficielle

de $10^{16}$ à $10^{19}$ atomes/cm$^3$.

On procède à une diffusion de type P (aluminium ou gallium par exemple) pour former les couches P1 et P2 sur la deuxième et la première face respectivement.

Après désoxydation superficielle totale, on crée par oxydation thermique une couche de silice sur les deux faces (0,5 à 2 μm d'épaisseur).

On grave cette couche du côté de la région P2 pour dénuder les zones d'accès à la région de gâchette, et on creuse le silicium aux endroits dénudés, par voie chimique ou par plasma pour obtenir une dénivellation de gâchette suffisante (5 à 40 microns).

Sur la deuxième face, côté P1, on ouvre des fenêtres dans l'oxyde aux endroits où on veut former les régions de cathode N2.

On diffuse alors un dopant de type N (arsenic ou phosphore), de manière à réaliser simultanément les couches N2 et N4 sur une profondeur de 5 à 40 μm, avec une concentration de surface supérieure à celle de la couche P1.

La plaquette de silicium est alors oxydée ou recouverte d'un oxyde déposé; des fenêtres sont ouvertes dans l'oxyde en vis à vis des couches N4 et P2 de manière à permettre la métallisation superficielle de cés couches; les affleurements des jonctions entre les couches N4 et P2 restent recouverts d'oxyde. On retire totalement l'oxyde sur la deuxième face; on découpe la rondelle de silicium s'il y a lieu en pastille individuelles correspondant chacune à un thyristor (découpe au laser par exemple).

Ensuite, on métallise les surfaces non recouvertes d'oxyde (metallisation de nickel effectuée par exemple par trempage).

La surface latérale de la pastille est usinée mécaniquement suivant une forme biseautée (tronc de cône ou pyramide dont la surface la plus grande est celle de la cathode). L'angle aigu est d'environ 40 à 60°.

La surface usinée est attaquée chimiquement puis recouverte d'un isolant de passivation minéral ou organique.

La pastille est alors montée dans un boîtier dont sortent trois électrodes.

Il faut remarquer, parmi les avantages de l'invention, que dans ce thyristor, c'est encore la couche centrale N1 qui contient le maximum de charges accumulées pendant une période de conduction; au moment du blocage, ces charges peuvent s'évacuer non seulement par les trous de court-circuit et par recombinaison naturelle, mais aussi par la gâchette. On aboutit à un bon compromis entre la facilité d'amorçage et la facilité de blocage du thyristor, évitant dans les deux sens la consommation d'un courant de gâchette trop important.

## Revendications

1. Thyristor blocable par la gâchette (14), constitué sur une pastille semiconductrice formée à partir d'un substrat de départ de type N peu dopé, la pastille comprenant principalement des régions de types de conductivité alternés et des métallisations superficielles d'anode (10), de cathode (12), et de gâchette (14), caractérisé en ce que les métallisations d'anode (10) et de gâchette (14) sont situées sur une première face de la pastille, et la métallisation de cathode (12) sur une deuxième face, et en ce que les régions alternées sont les suivantes: région N peu dopée du substrat de départ constituant une première couche centrale (N1); region N+ fortement dopée constituant une région de gâchette (N3) d'un côté de la première région centrale; région P diffusée localement dans la région de gâchette sur une partie seulement de la profondeur de celle-ci et constituant une region d'anode (P2), la région de gâchette et la région d'anode affleurant toutes deux sur la première face de la pastille et étant recouvertes respectivement par la métallisation de gâchette (14) et la métallisation d'anode (10); région P peu dopée constituant une deuxième région centrale (P1) de l'autre côté de la première région centrale; région N diffusée localement dans la deuxième région centrale de type P et constituant une région de cathode (N2) recouverte par la métallisation de cathode (12) déposée uniformément sur la majeure partie de la deuxième face de la pastille.

2. Thyristor selon la révendication 1, caractérisé en ce que la métallisation de gâchette (14) et la métallisation d'anode (10) sont interdigitées.

3. Thyristor selon la revendication 1, caractérisé en ce que les zones où la région de gâchette (N3) affleure sur la première face de la pastille sont en creux par rapport aux zones où la région d'anode (P2) affleure sur la même face.

4. Thyristor selon la revendication 1, caractérisé en ce que les bords de la pastille sont biseautés et forment un angle aigu avec la face de la cathode et un angle obtus avec la face de l'anode.

5. Thyristor selon la revendication 1, caractérisé en ce que des trous de court-circuits sont prévus, par lesquels la deuxième région centrale (P1) remonte à travers la région de cathode (N2) jusqu'à la métallisation de cathode (12).

## Patentansprüche

1. Über die Zundelektrode (14) blockierbarer Thyristor, bestehend aus einem Halbleiterplättchen, das ausgehend von einem gering dotierten Substrat vom N-Typ gebildet wird, wobei das Plättchen hauptsächlich Bereiche abwechselnder Leitfähigkeitstypen und oberflächliche Metallisierungen für die Anode (10), die Kathode (12) und die Zündelektrode (14) besitzt, dadurch gekennzeichnet, daß die Anoden- und Zündelektrodenmetallisierungen (10, 14) auf einer ersten Seite des Plättchens und die Kathodenmetallisierung (12) auf einer zweiten Seite des Plättchens angebracht sind, und daß die abwechselnden Bereiche folgende sind: gering dotierter N-Bereich des Ausgangssubstrats, der eine erste zentrale Schicht (N1) bildet, stark dotierter NA+ Bereich, der einen Zündelektrodenbereich (N3) auf einer Seite des ersten zentralen Bereichs bildet, P-Bereich, der örtlich in den Zündelektrodenbereich über nur einen Teil der Tiefe dieses Bereichs diffundiert ist und einen Anodenbereich (P2) bildet, wobei der Zündelektrodenbereich und der Anodenbbereich beide auf der ersten Seite des Plättchens zutagetreten und von einer Zündelektrodenmetallisierung (14) bzw. Anodenmetallisierung (10) bedeckt sind, gering dotierter P-Bereich, der einen zweiten zentralen Bereich (P1) auf der anderen Seite des ersten zentralen Bereichs bildet, N-Bereich, der örtlich in den zweiten zentralen Bereich vom P-Typ diffundiert ist und einen Kathodenbereich (N2) bildet, der von der Kathodenmetallisierung (12) bedeckt ist, welche gleichmäßig auf den größten Teil der zweiten Seite des Plättchens aufgebracht ist.

2. Thyristor nach Anspruch 1, dadurch gekennzeichnet, daß die Zündelektrodenmetallisierung (14) und die Anodenmetallisierung (10) ineinander verzahnt sind.

3. Thyristor nach Anspruch 1, dadurch gekennzeichnet, daß die Zonen, in denen der Zündelektrodenbereich (N3) auf der ersten Seite des Plättchens zutagetritt, bezüglich der Zonen zurückgesetzt sind, in denen der Anodenbereich (P2) auf derselben Seite zutagetritt.

4. Thyristor nach Anspruch 1, dadurch gekennzeichnet, daß die Ränder des Plättchens abgeschrägt sind und einen spitzen Winkel mit der Seite der Kathode sowie eine stumpfen Winkel mit der Seite der Anode bilden.

5. Thyristor nach Anspruch 1, dadurch gekennzeichnet, daß Kurzschlußlöcher vorgesehen sind, durch die der zweite zentrale Bereich (P1) durch den Kathodenbereich (N2) hindurch bis zur Kathodenmetallisierung (12) vordringt.

## Claims

1. A thyristor which may be blocked through the gate (14), realized on a semiconductor chip which is formed from a base substrate of the N type having a low doping rate, the chip mainly comprising regions of alternating conductivity types and superficial metallizations for the anode (10), the cathode (12) and the gate (14), characterized in that the anode metallization (10) and the gate metallization (14) are situated on a first chip surface and the cathode metallization (12) is situated on a second chip surface, and that the alternating regions are as follows: N region of a low doping rate of the base substrate constituting a first central layer (N1); N+ region of a high doping rate constituting a gate region (N3) on one side of the first central region; P region locally diffused into the gate region on a portion only of the depth of the latter and constituting an anode region (P2), the gate region and the anode region both appearing on the first surface of the chip and being covered respectively by the gate metallization (14) and the anode metallization (10); P region of low doping rate constituting a second central region (P1) on the other side of the central region; N region locally diffused into the second central region of P type and constituting a cathode region (N2) covered by the cathode metallization (12) which is uniformly deposited on the major part of the second chip surface.

2. A thyristor according to claim 1, characterized in that the gate metallization (14) and the anode metallization (10) are interlaced.

3. A thyristor according to claim 1, characterized in that the zones in which the gate region (N3) appears on the first surface of the chip are at a lower level than the zones in which the anode region (P2) appears on the same surface.

4. A thyristor according to claim 1, characterized in that the borders of the chip are slanted, their angle with the cathode surface being an acute angle and with the anode surface an obtuse angle.

5. A thyristor according to claim 1, characterized in that short-circuit holes are provided through which the second central region (P2) reaches the cathode metallization (12) through the cathode region (N2).

# FIG_1

Cathode

G

14  16  12  16  14  12  16  14

N2          N2

P1

N1

P2    P2        P2    P2

10

Anode

# FIG_2

Anode

G

14  16  10  16  14  10  16  14

N4    P 2    N4    P2    N4

N3          N3

18  N3

N1    N1

P1    P1

N2    N2        N2    N2

12

Cathode